# EUROPÄISCHE PATENTSCHRIFT

(11) **EP 0 549 623 B1**
(45) Veröffentlichungstag und Bekanntmachung des Hinweises auf die Patenterteilung: **30.11.1994**
(21) Anmeldenummer: 91915681.0
(22) Anmeldetag: 02.09.1991
(51) Int. Cl.: G11C 11/409, G11C 7/06

(54) **DYNAMISCHER HALBLEITERSPEICHER MIT LOKALEN UND HINSICHTLICH IHRER ANSTEUERFUNKTION OPTIMIERTEN LESEVERSTÄRKER-TREIBERSCHALTUNGEN**
DYNAMIC SEMICONDUCTOR MEMORY WITH LOCAL READ AMPLIFIER DRIVE CIRCUIT WITH OPTIMISED CONTROL FUNCTION
MEMOIRE DYNAMIQUE A SEMI-CONDUCTEURS AVEC DES CIRCUITS D'ATTAQUE ET D'AMPLIFICATION DE LECTURE LOCAUX OPTIMISABLES EN CE QUI CONCERNE LEUR FONCTION DE COMMANDE

(30) Priorität: 20.09.1990 DE 4029856
(43) Veröffentlichungstag der Anmeldung: 07.07.1993
(73) Patentinhaber: SIEMENS AKTIENGESELLSCHAFT, 80333 München (DE)
(72) Erfinder: GEIB, Heribert, D-8018 Grafing (DE)
(86) Internationale Anmeldenummer: DE9100695
(87) Internationale Veröffentlichungsnummer: WO9205557

(56) Entgegenhaltungen:
- EP-A- 0 184 031
- EP-A- 0 293 933
- DE-A- 4 001 340
- GB-A- 2 232 516
- US-A- 4 050 061
- US-A- 4 796 234
- IBM TECHNICAL DISCLOSURE BULLETIN, vol. 32, no. 2, July 1989, New York, US, pages 277-280; "Column-address controlled sense amplifier latching circuit for DRAM", see whole document
- IEEE INTERNATIONAL SOLID STATE CIRCUITS CONFERENCE, 25 February 1987, New York, US, pages 18-319; SHIMOHIGASHI et al.: "A 65ns CMOS DRAM with a twisted driveline sense amplifier", see page 18, left-hand column, lines 31-34; figure 3
- IEEE JOURNAL OF SOLID STATE CIRCUITS, vol. 25, no. 1, February 1990, New Yoek, US, pages 18-22; J. OKAMURA et al.: "Decoded-Source sense amplifier for high-density DRAM's", see the whole document and particular page 22, column 1, lines 2-5

## Beschreibung

Die Erfindung betrifft einen dynamischen Halbleiterspeicher nach dem Oberbegriff des Patentanspruchs 1.

Ein dynamischer Halbleiterspeicher dieser Art ist aus der Veröffentlichung mit dem Titel "An Experimental 16 Megabit DRAM With Reduced Peak-Current Noise" von B. Chin (Samsung) aus dem Digest of Technical Papers zum 1989 Symposium on VLSI Circuits (Seite 113 und 114) bekannt. Dabei handelt es sich um einen dynamischen Halbleiterspeicher, der Leitungen aufweist, die blockweise zu darüberliegenden metallischen Leiterbahnen durchkontaktiert sind (metall straping), um den Leitungswiderstand zu erniedrigen, und der verteilte, aus einem Transistor bestehende SAN- und SAP-Treiber besitzt, wobei pro Leseverstarker je ein SAN-Treibertransistor und ein SAP-Treibertransistor vorhanden ist. Da für jeden Leseverstärker somit zwei zusätzliche Transistoren erforderlich sind, ist dies mit einem relativ hohen zusätzlichen Platzbedarf verbunden.

Aus der europäischen Patentanmeldung mit der Veröffentlichungsnummer 0 293 933 ist es bekannt, Blöcken von Leseverstärkern individuelle Treiber zuzuordnen. Aus der amerikanischen Patentschrift Nr. 4,050,061 ist eine Parallelschaltung von Treibertransistoren zur Ansteuerung von Leseverstärkern bekannt.

In der deutschen Offenlegungsschrift DE 4001340 ist in Figur 5 ein in Blöcke unterteilter Speicher gezeigt, wobei jeder Block 1K Leseverstärker, einen SAN-Treiber und einen SAP-Treiber aufweist. Bei den Blöcken handelt es sich jedoch um Wortleitungsblöcke, die jedoch keine Vielzahl von Bitleitungsblöcken mit zugehörigen lokalen SAN-Treibern aufweisen.

Der Erfindung liegt die Aufgabe zugrunde, einen dynamischen Halbleiterspeicher der eingangs genannten Art anzugeben, der bei minimalem Chipflächenbedarf ein Optimum aus Bewertungssicherheit und kurzer Zugriffszeit ermöglicht. Diese Aufgabe wird erfindungsgemäß durch die im kennzeichnenden Teil des Patentanspruchs 1 angegebenen Merkmale gelöst.

Der mit der Erfindung erzielbare Vorteil liegt insbesondere darin, daß bei dem nach der Erfindung ausgebildeten dynamischen Halbleiterspeicher, genenüber des zitierten dynamischen Halbleierspeichers von Samsung, aufgrund eines nur blockweise benötigten n-phasigen Treibers mit optimierter Ansteuerfunktion und beispielsweise unter Ausnutzung einer ohnehin durch Leitungsdurchkonaktierungen gebildeten Lücke zwischen Leseverstärkerblöcken, kein zusätzlicher Platz benötigt wird.

Die Patentansprüche 2 bis 10 sind auf bevorzugte Ausbildungen des dynamischen Halbleiterspeichers gerichtet.

Die Erfindung wird nachfolgend anhand der Zeichnung näher erläutert. Dabei zeigt
- Figur 1: ein Spannungszeitdiagramm und eine Prinzipschaltung zur Erläuterung der Auswirkung von Treiberleitungswiderständen insbesondere bei globalen Treibern,
- Figur 2: eine Detailschaltung eines Leseverstärkers mit angekoppelter Speicherzelle und Bitleitungsersatzschaltung,
- Figur 3: eine Darstellung zur blockweisen Anordnung von lokalen SAN-Treibern bei einem erfindungsgemäßen dynamischen Halbleiterspeicher,
- Figur 4: eine Detailschaltung eines n-phasigen lokalen SAN-Treibers eines erfindungsgemäßen dynamischen Halbleiterspeichers,
- Figur 5: ein Spannungszeitdiagramm zur Erläuterung des n-phasigen lokalen SAN-Treibers von Figur 4,
- Figur 6: eine Darstellung zur blockweisen Anordnung von lokalen SAN- und SAP-Treibern bei einem erfindungsgemäßen dynamischen Halbleiterspeicher und
- Figur 7: eine Detailschaltung eines n-phasigen lokalen SAP-Treibers bei einem erfindungsgemäßen dynamischem Halbleiterspeicher.

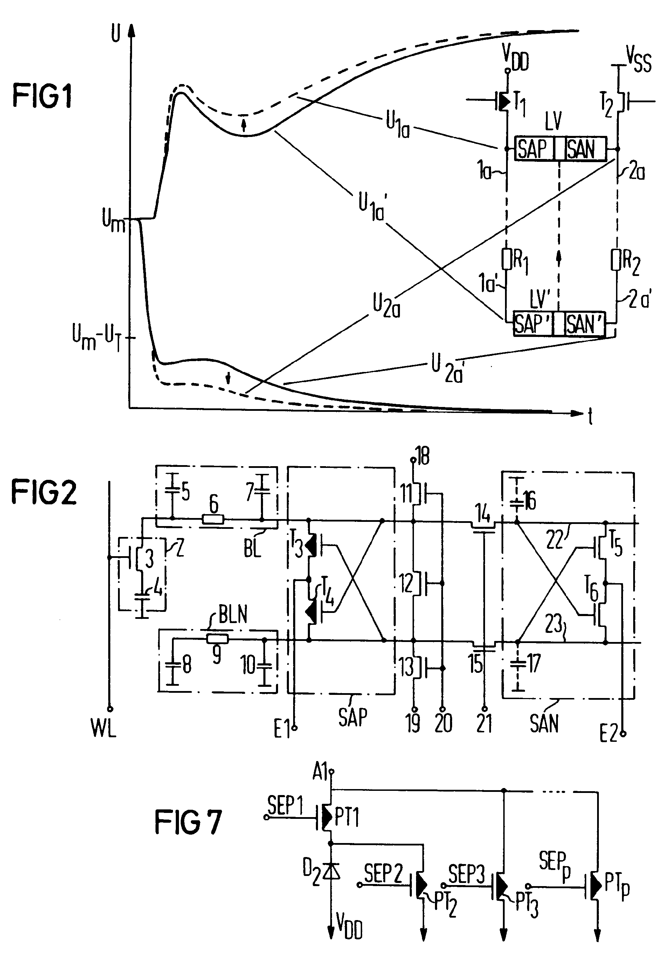

In Figur 1 ist ein Spannungszeitdiagramm, das die Spannungen U₁ₐ und U_{1a′} einer globalen SAP-Leitung 1a, 1a′ und die Spannungen U₂ₐ, U_{2a′} einer globalen SANN-Leitung 2a, 2a′ zeigt. Dabei befindet sich ein aus einem n-Kanal-Teil SAN und einem p-Kanal-Teil SAP bestehender Leseverstärker LV in unmittelbarer Nähe des p-Kanal-Treibertransistors T₁ und des n-Kanal-Transistors T₂. Der treibernahe SAP-Leitungsabschnitt la verbindet den Sourceanschluß des Transistors T1 mit dem p-Kanal-Teil SAP des Leseverstärkers LV und der treibernahe SANN-Leitungsabschnitt 2a verbindet den Drainanschluß des Treibertransistors T₂ mit dem n-Kanal-Teil SAN des Leseverstärkers LV. Ein treiberferner Leseverstärker LV′ besteht aus einem n-Kanal-Teil SAN′ und einem p-Kanal-Teil SAP′, wobei der n-Kanal-Teil SAN′ mit einem treiberfernen SANN-Leitungsabschnitt 2a′ und der p-Kanal-Teil SAP′ mit einem treiberfernen SAP-Leitungsabschnitt 1a′ verbunden ist. Zwischen dem treibernahen und dem treiberfernen SAP-Leitungsabschnitt besteht ein Leitungswiderstand R₁ und zwischen dem treibernahen und treiberfernen SANN-Leitungsabschnitt besteht ein Leitungswiderstand R₂. Die am treibernahen SAP-Leitungsabschnitt auftretende Spannung U₁ₐ und die am treibernahen SANN-Leitungsabschnitt 2a auftretende Spannung U₂ₐ ist im Spannungszeitdiagramm gestrichelt dargestellt und eine am treiberfernen SAP-Leitungsabschnitt 1a′ auftretende Spannung U₁ₐ, und eine am treiberfernen SANN-Leitungsabschnitt 2a′ auftretende Spannung U_{2a′} sind mit einer durchgezogenen Linie dargestellt. Der Drainanschluß des p-Kanal-Treibertransistors T₁ ist mit der Versorgungsspannung V_{DD} und der Sourceanschluß des n-Kanal-Treibertransistors T₂ ist mit Bezugspotential V_{SS} verbunden und die Beschaltung der Gateanschlüsse beider Transistoren ist nicht näher ausgeführt. Die Spannungswerte U₁ₐ und U_{1a′} der SAP-Leitung bewegen sich mit fortschreitender Zeit von einem Vorladepegel Uₘ in Richtung der Versorgungsspannung V_{DD} und die Spannungen U₂ₐ und U_{2a′} bewegen sich dabei von dem Vorladespannungspegel Uₘ in Richtung des Bezugspotentials V_{SS}, wobei dies beim treibernahen Leseverstärker LV jeweils schneller als beim treiberfernen Leseverstärker LV′ geschieht. Die unterschiedlichen Spannungsverläufe der Spannungen U₁ₐ und U_{1a′} bzw. der Spannungsverläufe von U₂ₐ und U_{2a′} werden durch eine stromabhängige Spannungsgegenkopplung, aufgrund des Spannungsabfalls am Widerstand R₁ und am Widerstand R₂, bewirkt.

Mit zunehmender Länge einer SAP- oder SANN-Leitung nimmt der elektrische Widerstand R₁ bzw. R₂ zu und verkleinert, durch den damit verbundenen Spannungsabfall die am Leseverstärker LV′ anliegende Steuerspannung. Sehr nachteilig ist dabei, daß treiberferne Leseverstärker schlechter ausgesteuert werden als treibernahe Leseverstärker und deshalb langsamer bewerten und anfälliger gegen äußere Störeinwirkungen sind. Ferner ist keine für alle Leseverstärker gleiche, optimierte Ansteuerfunktion angebbar, da der elektrische Widerstand zwischen Treiber und Leseverstärker unterschiedlich und gegenüber dem Innenwiderstand des Treibers nicht zu vernachlässigen ist. Werden andererseits die Treibertransistoren T₁ und T₂ so stark ausgesteuert, daß ein treiberferner Leseverstärker ausreichend ausgesteuert wird, so besteht bei den treibernahen Leseverstärkern, infolge der zu starken Ansteuerung, die Gefahr der Falschbewertung. Im Extremfall soll der vom Treiber am weitesten entfernte Leseverstärker eine logische Null und die anderen Leseverstärker jeweils eine logische Eins bewerten. In diesem Fall werden die Leseverstärker die eine logische Eins bewerten sollen vor dem Leseverstärker der eine logische Null bewerten soll aktiviert, wodurch beispielsweise ein Entladestrom über die SANN-Leitung und den Treibertransistor T₂ zum Bezugspotential V_{SS} fließt und auf der SANN-Leitung einen Spannungsabfall erzeugt. Der Leseverstärker, der die logische Null bewerten soll, wird erst bei Erreichen der Steuerspannung U = Uₘ - U_{T} (Uₘ = Vorladespannung und U_{T} = Einsatzspannung) mit der Bewertung beginnen. Ist beispielsweise die stromabhängige Spannungsgegenkopplung aufgrund des Widerstandes R₂ der SANN-Leitung 2a, 2a′ groß, so kann es relativ lange dauern bis dieser Steuerspannungspegel erreicht wird.

In Figur 2 ist eine mögliche Detailschaltung eines Leseverstärkers gezeigt, der mit einer Speicherzelle Z über eine Bitleitung BL gekoppelt ist und der mit einer Vergleichsbitleitung BLN verbunden ist. Die Speicherzelle Z besteht aus einem n-Kanal-MOS-Transistor 3, dessen Sourceanschluß über einen Zellenkondensator 4 mit Bezugspotential, dessen Drainanschluß mit der Bitleitung BL und dessen Gate mit der Wortleitung WL verbunden ist. Die Bitleitung BL ist durch eine Pi-Ersatzschaltung aus zwei Querkondensatoren 5 und 7 und einem Längswiderstand 6 dargestellt. Die Vergleichsbitleitung BLN ist in entsprechender Weise durch zwei Querkapazitäten 8 und 10 und einen Längswiderstand 9 repräsentiert. Die Bitleitung BL und die Vergleichsbitleitung BLN sind mit dem aus zwei kreuzgekoppelten p-Kanal-Transistoren T₃ und T₄ bestehenden p-Kanal-Teil SAP eines Leseverstärkers verbunden, wobei der Drainanschluß des Transistors T₃ und der Gateanschluß des Transistors T₄ mit der Bitleitung BL, der Drainanschluß des Transistors T₄ und der Gateanschluß des Transistors T₃ mit der Vergleichsbitleitung BLN und der Sourceanschluß des Transistors T₃ zusammen mit dem Sourceanschluß des Transistors T₄ mit einem SAF-Eingang El verbunden ist. Durch einen Transistor 12 ist die Bitleitung BL mit der Vergleichsbitleitung BLN kurzschließbar, durch den Transistor 11 ist die Bitleitung auf eine am Eingang 18 anliegende Spannung vorladbar und durch den Transistor 13 ist die Vergleichsbitleitung BLN auf eine am Eingang 19 anliegende Vorladespannung aufladbar. Die Gates der Transistoren 11 bis 13 sind gemeinsam über einen Eingang 20 ansteuerbar. Zwei Transfertransistoren 14 und 15 verbinden das Bitleitungspaar BL bzw. BLN des p-Kanal-Teils SAP mit Bitleitungsabschnitten 22 und 23 des n-Kanal-Teils SAN des Leseverstärkers und die Gates der Transistoren 14 und 15 sind über einen Eingang 21 gemeinsam ansteuerbar. Der n-Kanal-Teil SAN des Leseverstärkers besitzt zwei kreuzgekoppelte n-Kanal-Transistoren T₅ und T₆, wobei der mit dem Transistor 14 verbundene Bitleitungsabschnitt 22 mit dem Drainanschluß des Transistors T₅ und dem Gate des Transistors T₆, der mit dem Transfertransistor 15 verbundene Bitleitungsabschnitt 23 mit dem Drain des Transistors T₆ und dem Gate des Transistors T₅ und die Sourceanschlüße der Transistoren T₅ und T₆ mit einem SAN-Eingang E2 verbunden sind. Der Bitleitungsabschnitt 22 weist eine Kapazität 16 und der Bitleitungsabschnitt 23 weist eine Kapazität 17 gegenüber Bezugspotential auf.

Trotz einer auf High-Potential befindlichen Speicherzelle Z kann die Bitleitung BL zusammen mit dem Bitleitungsabschnitt 22, infolge von Bauelementunsymmetrien, schneller entladen werden als die Vergleichsbitleitung BLN zusammen mit dem zugehörigen Vergleichsbitleitungsabschnitt 23. Ist zum Beispiel die aus den Kapazitäten 7 und 16 gebildete Kapazität kleiner als die durch die Kapazitäten 10 und 17 gebildete Kapazität oder ist die Stromverstärkung des Transistors T₄ bzw. die des Transistors T₅ größer als die Verstärkung des Transistors T₃ bzw. des Transistors T₆ so kann die Bitleitung BL zusammen mit dem Bitleitungsabschnitt 22 fälschlicher Weise schneller entladen werden als die Vergleichsbitleitung BLN mit dem zugehörigen Bitleitungsabsschnitt 23, sofern ein zu rascher Anstieg der Spannung aus SAP-Eingang E1 bzw. ein zu rascher Abfall der Spannung am SAN-Eingang E2 erfolgt. Hieraus ergibt sich die Forderung einer optimierten Ansteuerfunktion für die Eingänge E1 und E2. Damit die optimierte Ansteuerfunktion für alle Leseverstärker weitgehend gleich ist, ist eine Spannungsansteuerung des SAP-Eingangs E1 und des SAN-Eingangs E2 erforderlich. Durch lokale SAN-Treiber bzw. SAP-Treiber läßt sich annähernd eine Spannungssteuerung erzielen.

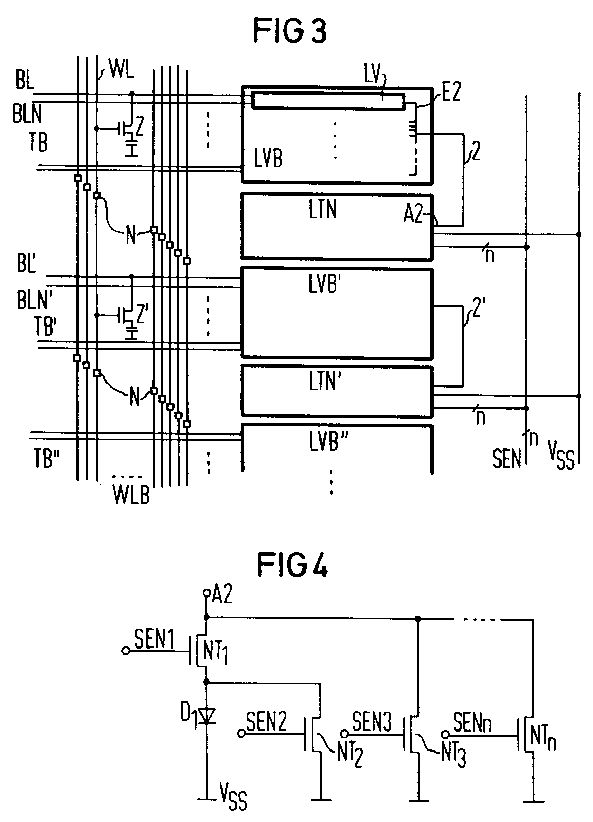

Figur 3 zeigt eine blockweise Anordnung von lokalen SAN-Treibern LTN, LTN′ ... jeweils zwischen Leseverstärkern LVB, LVB′, LVB˝ ... bei einem erfindungsgemäßen dynamischen Halbleiterspeicher. Ein Leseverstärkerblock LVB besteht aus einer Vielzahl von Leseverstärkern, die beispielsweise wie ein Leseverstärker LV mit einem Bitleitungspaar BL und BLN verbunden und jeweils über einen SAN-Eingang E2 ansteuerbar sind. Dabei sind die SAN-Eingänge E2 der zum Leseverstärkerblock LVB gehörigen Leseverstärker, wie zum Beispiel der Leseverstärker LVer eine lokale SANN-Leitung mit einem SAN-Treiberausgang A2 verbunden. Der lokale SAN-Treiber LTN wird über n Ansteuerleitungen SEN n-phasig angesteuert und ist mit Bezugspotential V_{SS} verbunden. Die Leseverstärker LVB, LVB′, LVB˝ ... sind Bitleitungsblöcken TB, TB′, TB˝ ... zugeordnet, wobei der Bitleitungsblock TB eine Vielzahl von Bitleitungspaaren, wie zum Beispiel das Bitleitungspaar BL und BLN, und der Bitleitungsblock TB′ eine Vielzahl von Bitleitungspaaren, wie zum Beispiel das Bitleitungspaar BL′ und BLN′ umfaßt. In Figur 3 ist stellvertretend für mehrere Wortleitungsblöcke ein Wortleitungsblock WLB, der aus mit Wortleitungsnägel N durchkontaktierten Wortleitungen WL besteht. Stellvertretend für ein gesamtes Zellenfeld sind Speicherzellen Z mit einer Bitleitung BL und einer Wortleitung WL sowie eine Speicherzelle Z′ mit einer Bitleitung BL′ und der Wortleitung WL dargestellt.

Entspricht günstigerweise ein Bitleitungsblock TB′ der Menge aller Bitleitungspaare zwischen zwei Durchkontaktierungsnägeln N einer Wortleitung WL, so kann gerade jeweils eine durch die Durchkontaktierungsnägel N entstehende Lücke zwischen den Leseverstärkerblöcken LVB, LVB′, LVB′ ... für lokale SAN-Treiber LTN, LTN′ ... genutzt werden. Durchkontaktierungsstellen für die Wortleitungsnägel N sind wesentlich breiter als die Wortleitung und zur Minimierung des Wortleitungsabstandes gestaffelt angeordnet, woraus sich eine ausreichende Lücke zwischen den Leseverstärkerblöcken ergibt. Statt einer globalen SANN-Leitung, die zum Beispiel mit 1024 Leseverstärkern verbunden ist, wird beispielsweise in einem erfindungsgemäßen dynamischen Halbleiterspeicher eine Anordnung mit 16 lokalen SAN-Treibern LTN, LTN′ ... und 16 lokalen SANN-Leitungen 2, 2′ ..., die jeweils mit 64 Leseverstärkern LV verbunden sind, benutzt. Bei diesem Beispiel reduzieren sich die Leitungswiderstände der lokalen SANN-Leitung gegenüber einer globalen SANN-Leitung um den Faktor 16 und kann somit gegenüber dem Innenwiderstand des jeweiligen lokalen SAN-Treibers weitgehend vernachlässigt werden. Durch die wesentlich geringeren Leitungswiderstände der lokalen SANN-Leitungen ist ebenfalls eine stromabhängige Spannungsgegenkopplung zu vernachlässigen und alle Leseverstärker LV eines Leseverstärkerblocks erhalten weitgehend dieselbe Ansteuerspannung an ihren SAN-Eingängen E2. Es ist Voraussetzung für den Einsatz eines SAN-Treibers mit optimierter Ansteuerfunktion.

Sind die Wortleitungen WL beispielsweise nur in einer Ebene niederohmigen Materials geführt, werden also keine Durchkontaktierungsnägel N angewandt, so müssen die Wortleitungen kürzer sein und es sind zusätzliche Wortleitungstreiber erforderlich. Die durch die zusätzlichen Wortleitungstreiber gebildeten Lücken zwischen Leseverstärkerblöcken können vorteilhafterweise für lokale SAN- bzw. SAP-Treiber genutzt werden.

In Figur 4 ist eine Detailschaltung eines n-phasigen lokalen SAN-Treibers eines erfindungsgemäßen dynamischen Halbleiterspeichers dargestellt. Die lokale SAN-Treiberschaltung besitzt minimal drei und maximal n n-Kanal-Transistoren, die im Minimalfall durch drei Ansteuerleitungen SEN1 bis SEN3 und im Maximalfall über n Ansteuerleitungen SEN1 bis SENn ansteuerbar sind. Der Drainanschluß eines n-Kanal-Transistors NT₁ ist mit einem SAN-Treiberausgang A2, der Sourceanschluß ist über eine in Flußrichtung geschaltete Diode D₁ mit Bezugspotential V_{SS} und das Gate des n-Kanal-Transistors NT₁ ist mit der Ansteuerleitung SEN1 verbunden. Zur Diode D₁ ist ein weiterer n-Kanal-Transistor NT₂ parallelgeschaltet und mit einer Ansteuerleitung SEN2 verbunden. Zwischen dem SAN-Treiberausgang A2 und dem Bezugspotential V_{SS} befindet sich ein dritter n-Kanal-Transistor NT₃, der durch eine dritte Ansteuerleitung SEN3 ansteuerbar ist. Zur besseren Annäherung einer optimalen Ansteuerfunktion können weitere n-Kanal-Transistoren bis zu einem Transistor NTₙ, dessen Gate mit einer Ansteuerleitung SENn verbunden ist, zum Transistor NT₃ parallelgeschaltet werden. Ob die Ansteuerleitungen SEN1 ... SENn außerhalb des lokalen SAN-Treibers bildbar sind oder ob sie in den lokalen SAN-Treibern jeweils durch Laufzeitschaltungen aus beispielsweise dem Signal der Ansteuerleitung SEN1 bildbar sind, ist hier von untergeordneter Bedeutung.

Die Diode D₁ ist eine mit CMOS-Prozeßschritten realisierte Bipolar-Diode, die auch an anderen Stellen eines erfindungsgemäßen dynamischen Halbleiterspeichers Verwendung findet und muß in ihrer Stromergiebigkeit so dimensioniert sein, daß in einer vertretbaren Zeit, die an der SANN-Leitung angeschlossenen Junction-Kapazitäten und die Leitungskapazität entladen werden. Durch Dimensionierung der einzelnen Transistoren und die Wahl der zeitlichen Ansteuerung kann die Steuerspannung stückweise, erst flach und dann steil abfallend, geformt werden.

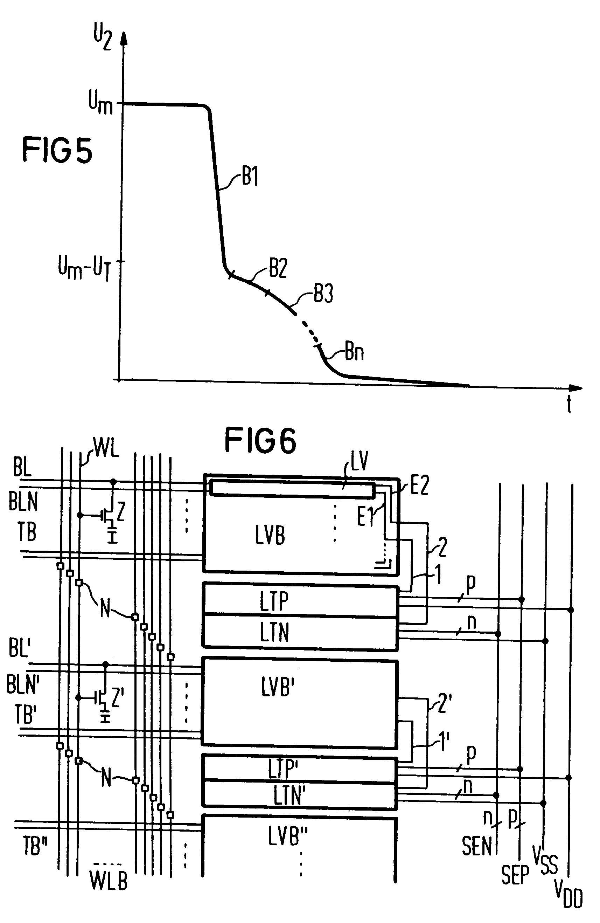

Die stückweise Bildung einer optimierten Ansteuerungsfunktion durch den in Figur 4 gezeigten lokalen n-phasigen SAN-Treiber wird in dem Spannungszeitdiagramm von Figur 5 dargestellt. Das Spannungszeitdiagramm zeigt die Spannung U₂ am SAN-Treiberausgang A2, sofern dieser über eine lokale SAN-Leitung mit Leseverstärkern verbunden ist. Sind alle Ansteuerleitungen SEN1 ... SENn auf Low-Potential, so entspricht die Spannung U₂ dem Vorladepegel Uₘ, sobald aber in einer ersten Phase B1 der Transistor NT₁ leitend wird sinkt die Ausgangsspannung U₂ auf einen ungefähr um die Einsatzspannung U_{T} eines n-Kanal-Lesetransistors reduzierten Wert Uₘ - U_{T} ab, wobei der Spannungswert Uₘ - U_{T} ungefähr der Schwellenspannung der Diode D1 entspricht. Die eigentliche Bewertung beginnt mit der zweiten Phase B2 in der der Kanalwiderstand des Transistors NT₁ zum Transistor NT₂ in Reihe geschaltet ist. Durch das weitere Hinzuschalten der Transistoren NT₃ bis NTₙ wird der Innenwiderstand des SAN-Treibers stufenweise gezielt verkleinert, wodurch die Ausgangsspannung U₂ gemäß einer optimierten Ansteuerfunktion auf das Bezugspotential abfällt.

Die Darstellung von Figur 6 zeigt eine blockweise Anordnung von lokalen SAN- und SAP-Treibern bei einem erfindungsgemäßen dynamischen Halbleiterspeicher. Ähnlich wie bei Figur 4 sind in Figur 6 Leseverstärkerblöcke LVB, LVB′, LVB˝ ... mit ihren zugehörigen Bitleitungsblöcken TB, TB′, TB˝ ... dargestellt. Ein Wortleitungsblock WLB besteht ebenfalls aus mit Wortleitungsnägeln N durchkontaktierten Wortleitungen WL, die stellvertretend für alle Speicherzellen eines Wortleitungsblocks mit einer Speicherzelle Z und einer Speicherzelle Z′ verbunden ist. Der Leseverstärkerblock LVB besteht aus einer Vielzahl von Leseverstärkern, wie zum Beispiel dem Leseverstärker LV, die mit Bitleitungspaaren, wie zum Beispiel dem Bitleitungspaar BL und BLN, verbunden sind. Der Leseverstärker LV vergleicht die Bitleitung BL, die mit der Speicherzelle Z verbunden ist, mit der Bitleitung BLN. Und in entsprechender Weise werden im Leseverstärkerblock LVB′ die Bitleitungen BL′, die mit der Zelle Z′ verbunden ist mit der Bitleitung BLN′ verglichen. Der wesentliche Unterschied zu Figur 4 sind die zusätzlich zu den lokalen n-phasigen SAN-Treibern vorhandenen lokalen p-phasigen SAP-Treiber LTP die jeweils durch p-Ansteuerleitungen SEP ansteuerbar sind. Die SAN-Eingänge E2 eines Leseverstärkers LV eines Leseverstärkerblocks LVB ist über eine lokale SANN-Leitung 2 mit dem SAN-Ausgang A2 des lokalen SAN-Treibers LTN verbunden. In ähnlicher Weise ist der SAP-Eingang E1 eines Leseverstärkers LV eines Leseverstärkerblocks LVB über eine lokale SAP-Leitung 1 mit einem SAP-Ausgang A1 des lokalen SAP-Treibers LTP verbunden. In entsprechender Weise gilt dies für weitere Leseverstärkerblöcke, wie zum Beispiel der Leseverstärkerblock LVB′, der über die lokale SAP-Treiberleitung 1′ und die lokale SANN-Treiberleitung 2′ mit dem lokalen SAP-Treiber LTP′ und dem lokalen SAN-Treiber LTN′, verbunden ist.

Durch die lokalen SAP-Treiber LTP, LTP′ ... ist, in ähnlicher Weise wie bei den lokalen SAN-Treibern, die Erzielung einer optimierten Ansteuerfunktion für die p-Kanal-Teile der Leseverstärker möglich. Lokale SAP-Treiber sind, aufgrund der niedrigeren Majoritätsträgerbeweglichkeit bei p-Kanal-Treibertransistoren, ca. dreimal so platzaufwendiger als entsprechende lokale SAN-Treiber. Die in Figur 7 gezeigte Detailschaltung eines n-phasigen lokalen SAP-Treibers bei einem erfindungsgemäßen dynamischen Halbleiterspeicher ist strukturell ähnlich dem, in Figur 4 dargestellten, lokalen SAN-Treiber. Der lokale SAP-Treiber besitzt einen p-Kanal-Transistor PT₁, dessen Drainanschluß mit einem SAP-Treiberausgang A1, dessen Sourceanschluß über eine in Flußrichtung geschaltete Diode D₂ mit der Versorgungsspannung V_{DD} und dessen Gate mit einer Steuerleitung SEP1 verbunden ist. Zur Diode D₂ ist ein p-Kanal-Transistor PT₂ parallelgeschaltet und das Gate des Transistors PT₂ ist mit einer Ansteuerleitung SEP2 verbunden. Zwischen dem SAP-Treiberausgang A1 und der Versorgungsspannung V_{DD} befindet sich ein p-Kanal-Transistor PT₃, dessen Gate über eine Ansteuerleitung SEP3 ansteuerbar ist. Zur besseren Approximation einer optimalen Ansteuerfunktion können weitere p-Kanal-Transistoren bis zu einem Transistor PTₚ, dessen Gate mit der Ansteuerleitung SEPp verbunden ist zum Transistor PT₃ parallelgeschaltet werden. Ähnlich wie beim, in Figur 4 beschriebenen, SAN-Treiber sind auch beim SAP-Treiber durch Laufzeitschaltungen aus beispielsweise dem Signal der Ansteuerleitung SEP1 die Signale für die weiteren Ansteuerleitungen SEP2 ... SEPn bildbar.

In einer ersten Phase, bei der die Ansteuerleitung SEP1 Low-Potential erhält, wird der Transistor PT₁ leitend und die Spannung am SAP-Treiberausgang A1 steigt von einer Vorladespannung Uₘ auf eine Spannung, die nur um die Schwellenspannung der Diode D₂ geringer ist als die Versorgungsspannung V_{DD}. Wird in einer zweiten Phase, bei der die Ansteuerleitung SEP2 Low-Potential erhält, der Transistors PT2 leitend so entsteht eine Reihenschaltung der Kanalwiderstände der Transistoren PT₁ und PT₂. In einer dritten bis p-ten Phase werden die Transistoren PT₃ bis PTₚ nacheinander durch Low-Potential auf den Steuerleitungen SEP3 bis SEPp leitend und damit der Innenwiderstand des SAP-Treibers stufenweise reduziert, wobei die Spannung am SAP-Treiberausgang A1 gemäß einer optimierten Ansteuerfunktion auf die Versorgungsspannung V_{DD} gebracht wird.

Sowohl bei dem SAN-Treiber als auch bei dem SAP-Treiber ist eine Kombination aus MOS-Transistoren und Bipolartransistoren vorstellbar. Die MOS-Transistoren können nicht vollständig durch Bipolartransistoren ersetzt werden, da aufgrund der bei Bipolartransistoren auftretenden Schwellenspannungen, ein Absinken auf V_{SS} bzw. ein Ansteigen auf V_{DD} nicht möglich ist.

## Patentansprüche

1. Dynamischer Halbleiterspeicher mit einer Speicherzellenanordnung, die aus mindestens einem Wortleitungsblock (WLB) besteht, mit jeweils aus einem n-Kanal-Teil und einem p-Kanal-Teil bestehenden Leseverstärkern, mit mindestens einem SAN-Treiber pro Wortleitungsblock zur Ansteuerung der n-Kanal-Teile der Leseverstärker und mit mindestens einem SAP-Treiber pro Wortleitungsblock zur Ansteuerung der p-Kanal-Teile der Leseverstärker, wobei der mindestens eine Wortleitungsblock aus einer Vielzahl von Bitleitungsblöcken (TB, TB′ ...) besteht und die Bitleitungsblöcke ihrerseits aus einer Vielzahl von Bitleitungspaaren (BL, BLN) bestehen,
**dadurch gekennzeichnet,**
- daß, sofern Wortleitungen (WL) mit darüberliegenden, relativ zu den Wortleitungen niederohmigen Leiterbahnen mit Worleitungsnägeln (N) durchkontaktiert sind, die jeweils zwischen zwei Wortleitungsnägeln (N) einer Wortleitung befindlichen Bitleitungspaare (BL′, BLN′) einen Bitleitungsblock bilden oder, sofern Wortleitungen nur in einer Ebene niederohmigen Materials geführt sind und zusätzliche Wortleitungstreiber vorgesehen sind, die jeweils zwischen zwei Wortleitungstreibern einer Wortleitung befindlichen Bitleitungspaare einen Bitleitungslbock bilden,
- daß pro Bitleitungsblock (TB) ein einzelner SAN-Treiber vorhanden ist, der einen lokalen SAN-Treiber (LTN) bildet und der so ansteuerbar ist, daß die Spannung an seinem Ausgang stückweise mit unterschiedlichen Steigungen abfällt, um ein schnelles und zugleich sicheres Lesen zu ermöglichen, und daß jeweils ein lokaler SAN-Treiber die n-Kanal-Teile (SAN) aller zu einem Bitleitungsblock gehörigen Leseverstärker (LV) über eine lokale SANN-Leitung (2) ansteuert.

2. Dynamischer Halbleiterspeicher nach Anspruch 1, **dadurch gekennzeichnet**, daß der zu einem Bitleitungsblock gehörige lokale SAN-Treiber (LTN) auf einem Halbleiterchip räumlich so angeordnet ist, daß er sich zwischen einer Anordnung aus zu dem Bitleitungsblock (TB) gehörigen Leseverstärkern (LVB) und einer Anordnung aus Leseverstärkern (LVB′), die zum unmittelbaren Nachbarbitleitungsblock (TB′) des Bitleitungsblocks (TB) gehören, befindet.

3. Dynamischer Halbleiterspeicher nach Anspruch 1, **dadurch gekennzeichnet**, daß jeweils ein lokaler SAN-Treiber eine Diode (D1) enthält, die kathodenseitig mit Bezugspotential (V_{SS}) und anodenseitig mit einem ersten Anschluß eines ersten n-Kanal-Transistors (NT₁) verbunden ist,
daß ein zweiter Anschluß des ersten n-Kanal-Transistors (NT₁) mit einem Treiberausgang (A2) des lokalen SAN-Treibers verbunden ist und der Gate-Anschluß des ersten n-Kanal-Transistors (NT₁) durch ein erstes Steuersignal (SEN1) ansteuerbar ist, daß zur Diode (D₁) ein zweiter n-Kanal-Transistor (NT₂) parallel geschaltet ist, dessen Gate durch ein zweites Steuersignal (SEN2) ansteuerbar ist und daß ein erster Anschluß eines dritten n-Kanal-Transistors (NT₃) mit dem Treiberausgang (A2) des lokalen SAN-Treibers und ein zweiter Anschluß des dritten n-Kanal-Transistors (NT₃) mit Bezugspotential (V_{SS}) verbunden ist und der Gate-Anschluß des dritten n-Kanal-Transistors (NT₃) durch ein drittes Steuersignal (SEN3) ansteuerbar ist.

4. Dynamischer Halbleiterspeicher nach Anspruch 3, **dadurch gekennzeichnet**, daß mindestens ein weiterer n-Kanal-Transistor (NTₙ) zu dem dritten n-Kanal- Transistor (NT₃) parallel geschaltet ist, wobei jeweils ein erster Anschluß des weiteren n-Kanal-Transistors (NTₙ) mit dem Treiberausgang (A2) des lokalen SAN-Treibers und ein zweiter Anschluß des weiteren n-Kanal-Transistors (NTₙ) mit Bezugspotential (V_{SS}) verbunden ist und der Gate-Anschluß des weiteren n-Kanal-Transistors (NTₙ) durch ein weiteres Steuersignal (SENn) ansteuerbar ist.

5. Dynamischer Halbleiterspeicher nach Anspruch 3 oder 4, **dadurch gekennzeichnet**, daß n-Kanal- Transistoren (NT₁ ... NTₙ) der lokalen SAN-Treiber unterschiedliche Kanalweiten besitzen.

6. Dynamischer Halbleiterspeicher nach Anspruch 1, **dadurch gekennzeichnet**, daß pro Bitleitungsblock (TB) zusätzlich zu einem lokalen SAN-Treiber (LTN), ein einzelner SAP-Treiber mit optimierter Ansteuerfunktion vorhanden ist, der einen lokalen SAP-Treiber (LTP) bildet und daß jeweils ein lokaler SAP-Treiber die p-Kanal-Teile (SAP) aller zu einem Bitleitungsblock gehörigen Leseverstärker (LV) über eine lokale SAP-Leitung (1) ansteuert.

7. Dynamischer Halbleiterspeicher nach Anspruch 6, **dadurch** **gekennzeichnet**, daß der zu einem Bitleitungsblock gehörige lokale SAP-Treiber (LTP) auf einem Halbleiterchip räumlich so angeordnet ist, daß er sich zwischen einer Anordnung aus zu dem Bitleitungsblock (TB) gehörigen Leseverstärkern (LVB) und einer Anordnung aus Leseverstärkern (LVB′), die zum unmittelbaren Nachbarbitleitungsblock (TB′) des Bitleitungsblocks (TB) gehören, befindet.

8. Dynamischer Halbleiterspeicher nach Anspruch 6, **dadurch gekennzeichnet**, daß jeweils ein lokaler SAP-Treiber eine Diode (D2) enthält, die anodenseitig mit einer Versorgungsspannung (V_{DD}) und kathodenseitig mit einem ersten Anschluß eines ersten p-Kanal-Transistors (PT₁) verbunden ist, daß ein zweiter Anschluß des ersten p-Kanal- Transistors (PT₁) mit einem Treiberausgang (A1) des lokalen SAP-Treibers verbunden ist und der Gate-Anschluß des ersten p-Kanal-Transistors (PT₁) durch ein erstes Steuersignal (SEP1) ansteuerbar ist, daß zur Diode (D2) ein zweiter p-Kanal-Transistor (PT₂) parallelgeschaltet ist, dessen Gate-Anschluß durch ein zweites Steuersignal (SEP2) ansteuerbar ist und daß ein erster Anschluß eines dritten p-Kanal-Transistors (PT₃) mit dem Treiberausgang (A1) des lokalen SAP-Treibers und ein zweiter Anschluß des dritten p-Kanal-Transistors (PT₃) mit der Versorgungsspannung (V_{DD}) verbunden ist und der Gate-Anschluß des dritten p-Kanal-Transistors (PT₃) durch ein drittes Steuersignal (SEP3) ansteuerbar ist.

9. Dynamischer Halbleiterspeicher nach Anspruch 8, **dadurch gekennzeichnet**, daß mindestens ein weiterer p-Kanal-Transistor (PTₚ) zu dem dritten p-Kanal-Transistor (PT₃) parallelgeschaltet ist, wobei jeweils ein erster Anschluß des weiteren p-Kanal-Transistors (PTₚ) mit dem Treiberausgang (A1) des lokalen SAP-Treibers und ein zweiter Anschluß des weiteren p-Kanal-Transistors (PTₚ) mit der Versorgungsspannung (V_{DD}) verbunden ist und der Gate-Anschluß des weiteren p-Kanal-Transistors (PTₚ) durch ein weiteres Steuersignal (SEPₚ) ansteuerbar ist.

10. Dynamischer Halbleiterspeicher nach Anspruch 8 oder 9, **dadurch** **gekennzeichnet**, daß p-Kanal- Transistoren (PT₁ ... PTₚ) der lokalen SAP-Treiber unterschiedliche Kanalweiten besitzen.

## Claims

1. Dynamic semiconductor memory having a memory cell arrangement which comprises at least one word line block (WLB), having read amplifiers comprising in each case an n-channel part and a p-channel part, having at least one SAN driver per word line block for driving the n-channel parts of the read amplifiers, and having at least one SAP driver per word line block for driving the p-channel parts of the read amplifiers, the at least one word line block comprising a multiplicity of bit line blocks (TB, TB′...) and the bit line blocks in turn comprising a multiplicity of bit line pairs (BL, BLN), characterized in that, to the extent that word lines (WL) are made contact with through the board, said word lines having superimposed conductor tracks which are of low impedance relative to the word lines and have word line pins (N), the bit line pairs (BL′, BLN′) located in each case between two word line pins (N) of a word line form a bit line block and, to the extent that word lines are guided only in a plane of low-impedance material and additional word line drivers are provided, the bit line pairs located in each case between two word line drivers of a word line form a bit line block, in that a single SAN driver is present for each bit line block (TB), forms a local SAN driver (LTN) and can be driven such that the voltage at its output falls in a piecemeal manner, with different gradients, to enable a fast and at the same time reliable reading, and in that in each case one local SAN driver drives the n-channel parts (SAN) of all read amplifiers (LV) belonging to a bit line block via a local SANN line (2).

2. Dynamic semiconductor memory according to claim 1, characterized in that the local SAN driver (LTN) belonging to a bit line block is arranged spatially on a semiconductor chip in such a way that it is located between an arrangement of read amplifiers (LVB) belonging to the bit line block (TB) and an arrangement of read amplifiers (LVB′) which belong to the bit line block (TB′) directly adjacent to the bit line block (TB).

3. Dynamic semiconductor memory according to claim 1, characterized in that in each case one local SAN driver contains a diode (D1), which is connected to reference potential (V_{SS}) on the cathode side and is connected to a first terminal of a first n-channel transistor (NT₁) on the anode side, in that a second terminal of the first n-channel transistor (NT₁) is connected to a driver output (A2) of the local SAN driver and the gate terminal of the first n-channel transistor (NT₁) can be driven by a first control signal (SEN1), in that a second n-channel transistor (NT₂) is connected in parallel with the diode (D₁) and its gate can be driven by a second control signal (SEN2), and in that a first terminal of a third n-channel transistor (NT₃) is connected to the driver output (A2) of the local SAN driver, and a second terminal of the third n-channel transistor (NT₃) is connected to reference potential (V_{SS}), and the gate terminal of the third n-channel transistor (NT₃) can be driven by a third control signal (SEN3).

4. Dynamic semiconductor memory according to claim 3, characterized in that at least one further n-channel transistor (NTₙ) is connected in parallel with the third n-channel transistor (NT₃), in each case a first terminal of the further n-channel transistor (NTₙ) being connected to the driver output (A2) of the local SAN driver, and a second terminal of the further n-channel transistor (NTₙ) being connected to reference potential (V_{SS}), and it being possible for the gate terminal of the further n-channel transistor (NTₙ) to be driven by a further control signal (SENn).

5. Dynamic semiconductor memory according to claim 3 or 4, characterized in that n-channel transistors (NT₁ ... NTₙ) of the local SAN drivers have different channel widths.

6. Dynamic semiconductor memory according to claim 1, characterized in that, in addition to a local SAN driver (LTN), a single SAP driver with optimized drive function is present for each bit line block (TB) and forms a local SAP driver (LTP), and in that in each case one local SAP driver drives the p-channel parts (SAP) of all read amplifiers (LV) belonging to a bit line block via a local SAP line (1).

7. Dynamic semiconductor memory according to claim 6, characterized in that the local SAP driver (LTP) belonging to a bit line block is arranged spatially on a semiconductor chip in such a way that it is located between an arrangement of read amplifiers (LVB) belonging to the bit line block (TB) and an arrangement of read amplifiers (LVB′) which belong to the bit line block (TB′) directly adjacent to the bit line block (TB).

8. Dynamic semiconductor memory according to claim 6, characterized in that in each case one local SAP driver contains a diode (D2), which is connected to a supply voltage (V_{DD}) on the anode side and is connected to a first terminal of a first p-channel transistor (PT₁) on the cathode side, in that a second terminal of the first p-channel transistor (PT₁) is connected to a driver output (A1) of the local SAP driver and the gate terminal of the first p-channel transistor (PT₁) can be driven by a first control signal (SEP1), in that a second p-channel transistor (PT₂) is connected in parallel with the diode (D2) and its gate terminal can be driven by a second control signal (SEP2), and in that a first terminal of a third p-channel transistor (PT₃) is connected to the driver output (A1) of the local SAP driver, and a second terminal of the third p-channel transistor (PT₃) is connected to the supply voltage (V_{DD}), and the gate terminal of the third p-channel transistor (PT₃) can be driven by a third control signal (SEP3).

9. Dynamic semiconductor memory according to claim 8, characterized in that at least one further p-channel transistor (PTₚ) is connected in parallel with the third p-channel transistor (PT₃), in each case a first terminal of the further p-channel transistor (PTₚ) being connected to the driver output (A1) of the local SAP driver, and a second terminal of the further p-channel transistor (PTₚ) being connected to the supply voltage (V_{DD}), and it being possible for the gate terminal of the further p-channel transistor (PTₚ) to be driven by a further control signal (SEPₚ).

10. Dynamic semiconductor memory according to claim 8 or 9, characterized in that p-channel transistors (PT₁ ... PTₚ) of the local SAP drivers have different channel widths.

## Revendications

1. Mémoire dynamique à semiconducteurs comportant un ensemble de cellules de mémoire, qui est constitué par au moins un bloc de lignes de transmission de mots (WLB), et comportant des amplificateurs de lecture constitués chacun par une partie à canal n et une partie à canal p, et comportant au moins un étage d'attaque SAN pour chaque bloc de lignes de transmission de mots pour la commande des parties à canal n des amplificateurs de lecture, et au moins un étage d'attaque SAP pour chaque bloc de lignes de transmission de mots pour la commande des parties à canal p des amplificateurs de lecture, au moins un bloc de lignes de transmission de mots étant constitué par une multiplicité de blocs de lignes de transmission de bits (TB, TB′...), et les blocs de lignes de transmission de bits étant constitués pour leur part par une multiplicité de couples de lignes de transmission de bits (BL, BLN),
caractérisée par le fait
- que, dans la mesure où des lignes de transmission de mots (WL) sont placées en contact, par des voies conductrices surjacentes, possédant une faible valeur ohmique par rapport aux lignes de transmission de mots, avec des aiguilles (N) de lignes de transmission de mots, les couples de lignes de transmission de bits (BL′, BLN′), qui sont situés respectivement entre deux aiguilles (N) d'une ligne de transmission de mots, forment un bloc de ligne de transmission de bits ou bien, dans la mesure où des lignes de transmission de mots s'étendent uniquement dans un plan d'un matériau de faible valeur ohmique et où des étages d'attaque supplémentaires de lignes de transmission de mots sont prévus, les couples de lignes de transmission de bits, qui sont situés respectivement entre deux étages d'attaque d'une ligne de transmission de mots, forment un bloc de lignes de transmission de bits,
- que pour chaque bloc de lignes de transmission de bits (TB) il est prévu un étage d'attaque SAN individuel, qui forme un étage d'attaque SAN local (LTN) et peut être commandé de telle sorte que la tension présente à sa sortie chute d'une manière échelonnée avec des pentes différentes de manière à permettre une lecture rapide et simultanément sûre, et que respectivement un étage d'attaque SAN local commande les parties à canal n (SAN) de tous les amplificateurs de lecture (LV) associés à un bloc de lignes de transmission de bits, par l'intermédiaire d'une ligne SAN locale (2).

2. Mémoire dynamique suivant la revendication 1, caractérisée par le fait que l'étage d'attaque SAN local (LTN), qui est associé à un bloc de lignes de transmission de bits, est disposé physiquement sur une microplaquette à semiconducteurs de telle sorte qu'il est situé entre un dispositif formé par des amplificateurs de lecture (LVB) associés au bloc de lignes de transmission de lignes (TB), et un dispositif d'amplificateurs de lecture (LVB′), qui font partie du bloc de lignes de transmission de bits (TB′) directement voisin du bloc de lignes de transmission de bits (TB).

3. Mémoire dynamique suivant la revendication 1, caractérisée par le fait que respectivement un étage d'attaque SAN local contient une diode (D1), qui est reliée, côté cathode, au potentiel de référence (V_{SS}) et, côté anode, à une première borne d'un premier transistor à canal n (NT₁), qu'une seconde borne du premier transistor à canal n (NT₁) est reliée à la sortie (A2) de l'étage d'attaque SAN local et que la borne de grille du premier transistor à canal n (NT₁) peut être commandé par un premier signal de commande (SEN1), qu'en parallèle avec la diode (D₁) est branché un second transistor à canal n (NT₂), dont la grille peut être commandée par un second signal de commande (SEN2), et qu'une troisième borne d'un troisième transistor à canal n (NT₃) est reliée à la sortie (A2) de l'étage d'attaque (SAN) local et qu'une seconde borne du troisième transistor à canal n (NT₃) est reliée au potentiel de référence (V_{SS}) et que la borne de grille du troisième transistor à canal n (NT₃), peut être commandée au moyen d'un troisième signal de commande (SEN3).

4. Mémoire dynamique suivant la revendication 3, caractérisée par le fait qu'au moins un autre transistor à canal n (NTₙ) est branché en parallèle avec le troisième transistor à canal n (NT₃), auquel cas respectivement une première borne de l'autre transistor à canal n (NTₙ) est reliée à la sortie (A2) de l'étage d'attaque SAN local et une seconde borne de l'autre transistor à canal n (NTₙ) est reliée au potentiel de référence (V_{SS}), tandis que la borne de grille de l'autre transistor à canal n (NTₙ) peut être commandée par un autre signal de commande (SENn).

5. Mémoire dynamique suivant la revendication 3 ou 4, caractérisée par le fait que les transistors à canal n (NT₁...NTₙ) des étages d'attaque SAN locaux possèdent des canaux ayant des largeurs différentes.

6. Mémoire dynamique suivant la revendication 1, caractérisée par le fait que pour chaque bloc de lignes de transmission de bits (TB), il est prévu, en plus d'un étage d'attaque SAN local (NTL), un étage d'attaque SAP individuel possédant une fonction de commande optimisée et qui forme un étage d'attaque SAP local (LTP), et que respectivement un étage d'attaque SAP local commande les parties à canal p (SAP) de tous les amplificateurs de lecture (LV) associés à un bloc de lignes de transmission de bits, par l'intermédiaire d'une ligne SAP locale (1).

7. Mémoire dynamique suivant la revendication 6, caractérisé par le fait que l'étage d'attaque SAP local (LTP), qui est associé à un bloc de lignes de transmission de bits, est disposé physiquement sur une plaquette à semiconducteurs de telle sorte qu'il se situe entre un dispositif formé par des amplificateurs de lecture (LVB) associés au bloc de lignes de transmission de bits (TB), et un dispositif formé d'amplificateurs de lecture (LVB′), qui font partie du bloc de lignes de transmission de bits (TB′) directement voisin du bloc de lignes de transmission de bits (TB).

8. Mémoire dynamique suivant la revendication 6, caractérisée par le fait que respectivement un étage d'attaque SAP local comporte une diode (D2), qui est reliée, côté anode, à une tension d'alimentation (V_{DD}), et côté cathode, à une première borne d'un premier transistor à canal p (PT₁), qu'une seconde borne du premier transistor à canal p (PT₁) est reliée à une sortie (A1) de l'étage d'attaque SAP local et que la borne de grille du premier transistor à canal p (PT₁) peut être commandée par un premier signal de commande (SEP1), qu'en parallèle avec la diode (D2) est branché un second transistor à canal p (PT₂), dont la borne de grille peut être commandée par un second signal de commande (SAP₂), et qu'une première borne d'un troisième transistor à canal p (PT3) est reliée à la sortie (A1) de l'étage d'attaque SAP local et qu'une seconde borne du troisième transistor à canal p (PT₃) est reliée à la tension d'alimentation (V_{DD}) et que la borne de grille du troisième transistor à canal p (PT₃) peut être commandée au moyen d'un troisième signal de commande (SEP3).

9. Mémoire dynamique suivant la revendication 8, caractérisée par le fait qu'au moins un autre transistor à canal p (PTₚ) est branché en parallèle avec le troisième transistor à canal p (PT₃), auquel cas respectivement une borne de l'autre transistor à canal p (PTₚ) est reliée à la sortie (A1) de l'étage d'attaque SAP local, et une seconde borne de l'autre transistor à canal p (PTₚ) est reliée à la tension d'alimentation (V_{DD}), et la borne de grille de l'autre transistor à canal p (PTₚ) peut être commandée au moyen d'un autre signal de commande (SEPₚ).

10. Mémoire dynamique suivant la revendication 8 ou 9, caractérisée par le fait que des transistors à canal p (PT₁... PTₚ) de l'étage d'attaque SAP local possèdent des canaux ayant des largeurs différentes.
